# EUROPEAN PATENT SPECIFICATION

(11) **EP 2 551 894 B1**
(45) Date of publication and mention of the grant of the patent: **26.09.2018**
(21) Application number: 11759647.8
(22) Date of filing: 24.03.2011
(51) Int. Cl.: H01J 37/32, H01L 21/67

(54) **REGION TEMPERATURE-CONTROLLED STRUCTURE**
BEREICHSTEMPERATURGESTEUERTE STRUKTUR
STRUCTURE CONTROLÉE EN TEMPÉRATURE PAR ZONES

(30) Priority: 25.03.2010 JP 2010069083
(43) Date of publication of application: 30.01.2013
(73) Proprietor: Tokyo Electron Limited, Tokyo 107-6325 (JP)
(72) Inventor: SASAKI, Yasuharu, Nirasaki-shi Yamanashi 407-8511 (JP)
(74) Representative: Manitz Finsterwald Patentanwälte PartmbB
(86) International application number: PCT/JP2011/058155
(87) International publication number: WO 2011/118847

(56) References cited:
- JP-A- 9 255 474
- JP-A- H09 255 474
- JP-A- 2000 294 868
- JP-A- 2004 292 297
- JP-A- 2004 292 297
- JP-A- 2005 005 434
- US-A1- 2004 115 947
- US-A1- 2006 076 108
- US-A1- 2007 256 785

## Description

### [Technical Field]

The present disclosure relates to an area temperature control structure having a multiple number of areas of which surface temperatures are controlled to have different temperatures.

### [Background Art]

In a substrate processing apparatus configured to perform a plasma process on a semiconductor wafer (hereinafter, simply referred to as a "wafer") as a substrate, as a mounting table (susceptor) for mounting thereon the wafer, there is known a susceptor having a mounting surface that is divided into a multiple number of annular temperature areas. The multiple number of annular temperature areas are controlled individually, and the wafer is supported over the respective annular temperature areas.

In an area temperature control structure of which surface is controlled to have a multiple number of temperature areas such as the above-mentioned susceptor supporting the wafer over the respective annular temperature control areas, or in an assembly structure having a multiple number of temperature area members controlled to have different temperatures, when controlling temperatures of the respective areas individually, heat may be transferred at joint surfaces or interfaces between the adjacent annular temperature areas. Therefore, thermal efficiency may be deteriorated, and it may further be difficult to maintain temperature differences between the areas.

Accordingly, in order to prevent the thermal efficiency from being deteriorated during the temperature control and to maintain the temperature difference between the areas in the area temperature control structure or the assembly structure, there has been developed a technique for providing a thermal insulator between the adjacent areas or forming the adjacent areas with different raw materials having different thermal conductivities (see, for example, Patent Document 1).

Patent Document 1: Japanese Patent Laid-open Publication No. 2004-292297

Further conventional area temperature control structures are described in documents US 2007 / 0 256 785 A1 and US 2006 / 0 076 108 A1.

### [Disclosure of the Invention]

### [Problems to Be Solved by the Invention]

If a thermal insulator is disposed between the areas controlled to have different temperatures in the area temperature control structure, it may be possible to prevent thermal conduction between the adjacent areas via the thermal insulator. However, an area temperature directly above the thermal insulator may become higher than adjacent temperatures due to heat introduced from a direction intersecting with an arrangement direction of the areas. As a result, a temperature singularity (hereinafter, referred to as a "hot spot") may be formed. The hot spot may not only deteriorate temperature uniformity of the area controlled to have a certain temperature but also deteriorate thermal efficiency.

In view of the foregoing problem, illustrative embodiments provide the area temperature control structure having a structure main body, which is made of an isotropic thermal conductive material, including a first and a second area controlled to have different temperatures, and capable of maintaining a temperature difference between the first and second areas by suppressing thermal conduction in the arrangement direction of the first and second areas while preventing the hot spot from being formed by allowing heat introduced from the direction intersecting with the arrangement direction of the first and second areas to be uniformly transferred.

### [Means for Solving the Problems]

In order to obtain the above-mentioned objects, there is provided an area temperature control structure including a structure main body, which is made of an isotropic thermal conductive material, including a first area and a second area of which surface temperatures are controlled to have different temperatures; a first annular medium path and a second annular medium path formed within the first and second areas, respectively; and an anisotropic thermal conductive layer provided within the structure main body. Also, a thermal conductivity of the anisotropic thermal conductive layer in an arrangement direction of the first and second areas is smaller than a thermal conductivity of the anisotropic thermal conductive layer in a direction intersecting with the arrangement direction of the first and second areas. The anisotropic thermal conductive layer has a T-shaped cross section. The T-shaped cross section is orthogonal to a flowing direction of a heat exchange medium in the first annular medium path and the second annular medium path. A vertical portion of the T-shaped cross section is positioned between the first annular medium path and the second annular medium path, and both ends of a horizontal portion of the T-shaped cross section are positioned on upper portions of the first and second annular medium paths, respectively. The vertical portion and the horizontal portion of the anisotropic thermal conductive layer are all made of an anisotropic thermal conductive material.

In accordance with the illustrative embodiment, the area temperature control structure includes the first and second areas of which the surface temperatures are controlled to have different temperatures, and the anisotropic thermal conductive layer provided between the first and second areas. Further, the thermal conductivity of the anisotropic thermal conductive layer in the arrangement direction of the first and second areas is smaller than the thermal conductivity in the direction intersecting with the arrangement direction of the first and second areas. Accordingly, a temperature difference between the first and second areas can be maintained by suppressing thermal conduction in the arrangement direction of the first and second areas. Further, by allowing heat introduced from the direction intersecting with the arrangement direction of the first and second areas to be uniformly transferred, a hot spot can be prevented from being formed.

Further, a ratio of the thermal conductivity of the anisotropic thermal conductive layer in the direction intersecting with the arrangement direction of the first and second areas to the thermal conductivity thereof in the arrangement direction of the first and second areas may be equal to or larger than about 7.

The anisotropic thermal conductive layer may be made of a composite material selected from titan-carbon, aluminum-carbon fiber, titan-aluminum, and glass-shaped carbon-carbon.

The area temperature control structure may be a plate-shaped structure in which the first and second areas are arranged in a predetermined direction, and the anisotropic thermal conductive layer may be formed to penetrate through the plate-shaped structure in a thickness direction thereof.

The area temperature control structure may be a mounting table, an upper electrode plate, or a deposit shield of a substrate processing apparatus.

### [Brief Description of the Drawings]

Fig. 1 is a cross sectional view illustrating a schematic configuration of a substrate processing apparatus including an area temperature control structure in accordance with an illustrative embodiment.
Fig. 2 is a cross sectional view illustrating a schematic configuration of an example area temperature control structure in accordance with the illustrative embodiment.
Fig. 3A is a perspective view illustrating a cross sectional piece of an annular boundary member provided between a first annular temperature area and a second annular temperature area in Fig. 2.
Fig. 3B is a perspective view illustrating a cross sectional piece of an annular boundary member provided between the first annular temperature area and the second annular temperature area shown in Fig. 2.
Fig. 3C is a perspective view illustrating a cross sectional piece of an annular boundary member provided between the first annular temperature area and the second annular temperature area shown in Fig. 2.
Fig. 3D is a perspective view illustrating a cross sectional piece of an annular boundary member provided between the first annular temperature area and the second annular temperature area shown in Fig. 2.
Fig. 4 is a graph showing thermal conduction properties of the annular boundary members shown in Figs. 3A to 3D in a horizontal radial direction.
Fig. 5 is a graph showing thermal conduction properties of the annular boundary members shown in Figs. 3A to 3D in a vertical direction.
Fig. 6 is a cross sectional view illustrating a schematic configuration of a susceptor as an area temperature control structure in accordance with a first illustrative embodiment.
Fig. 7 is a cross sectional view illustrating a modification example of the susceptor of Fig. 6.
Fig. 8 is a cross sectional view illustrating a deposit shield as an area temperature control structure in accordance with a second illustrative embodiment.
Fig. 9 is a cross sectional view illustrating an upper electrode plate as an area temperature control structure in accordance with a third illustrative embodiment.

### [Best Mode for Carrying out the Invention]

Hereinafter, illustrative embodiments will be described in detail with reference to the accompanying drawings.

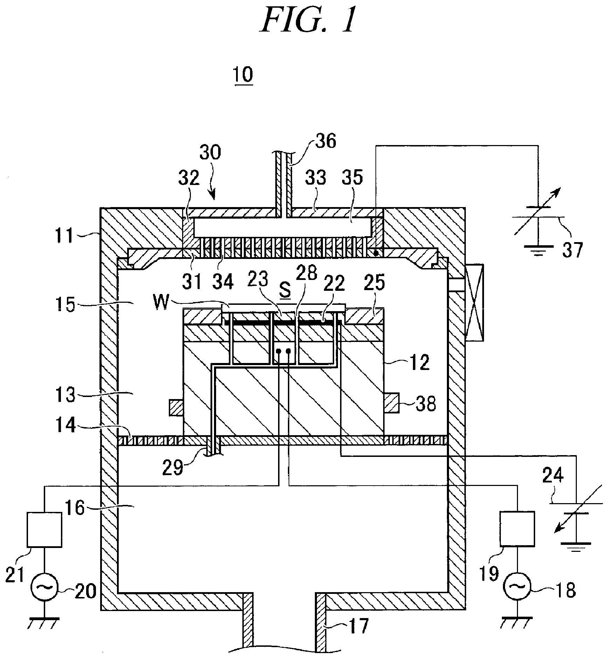

Fig. 1 is a cross sectional view illustrating a schematic configuration of a substrate processing apparatus including an area temperature control structure in accordance with an illustrative embodiment.

In Fig. 1, the substrate processing apparatus is configured to perform a certain plasma etching process on a wafer.

A substrate processing apparatus 10 includes a chamber 11 for accommodating therein a wafer W. A circular plate-shaped susceptor 12 for mounting thereon the wafer W is disposed within the chamber 11. A side exhaust path 13 is formed between an inner sidewall of the chamber 11 and a side surface of the susceptor 12. An exhaust plate 14 is provided on the way of the side exhaust path 13.

The exhaust plate 14 is a plate-shaped member having a multiple number of through holes and serves as a partition plate that partitions an inside of the chamber 11 into an upper region and a lower region. In the upper region (hereinafter, referred to as "processing chamber") 15 of the inside of the chamber 11 partitioned by the exhaust plate 14, plasma is generated as will be described below. Further, the lower region (hereinafter, referred to as "exhaust chamber (manifold)") 16 of the inside of the chamber 11 is connected with an exhaust pipe 17 for exhausting a gas within the chamber 11. The exhaust plate 14 confines or reflects plasma generated in the processing chamber 15. As a result, it is possible to prevent the plasma from being leaked into the manifold 16.

A TMP (Turbo Molecular Pump) and a DP (Dry Pump) (both are not shown) are connected to the exhaust pipe 17, and these pumps are configured to evacuate and depressurize the inside of the chamber 11 to a certain pressure level. Further, an internal pressure of the chamber 11 is controlled by an APC valve (not shown).

A first high frequency power supply 18 is connected to the susceptor 12 within the chamber 11 via a first matching unit 19, and a second high frequency power supply 20 is connected to the susceptor 12 via a second matching unit 21. The first high frequency power supply 18 applies a high frequency power of a relatively low frequency of e.g., about 2 MHz for bias to the susceptor 12, and the second high frequency power supply 20 applies a high frequency power of a relatively high frequency of e.g., about 60 MHz for plasma generation to the susceptor 12. In this configuration, the susceptor 12 serves as an electrode. Further, the first matching unit 19 and the second matching unit 21 are configured to reduce reflection of the high frequency powers from the susceptor 12 so that efficiency of applying the high frequency powers to the susceptor 12 can be maximized.

An electrostatic chuck 23 having an electrostatic electrode plate 22 embedded therein is provided on an upper portion of the susceptor 12. The electrostatic chuck 23 has a step-shaped portion and is made of, but not limited to, a ceramic.

The electrostatic electrode plate 22 is connected with a DC power supply 24. When a positive DC voltage is applied to the electrostatic electrode plate 22, a negative electric potential is generated on a surface (hereinafter, referred to as a "rear surface") of the wafer W facing the electrostatic chuck 23. As a result, an electric potential difference is generated between the electrostatic electrode plate 22 and the rear surface of the wafer W. Accordingly, the wafer W is attracted to and held on the electrostatic chuck 23 by a Coulomb force or a Johnsen-Rahbek force generated due to the electric potential difference.

Further, a focus ring 25 is mounted on a horizontal portion of the step-shaped portion of the electrostatic chuck 23 so as to surround the wafer W attracted to and held on the electrostatic chuck 23. The focus ring 25 is made of, e.g., silicon (Si) or silicon carbide (SiC).

By way of example, an annular medium path extended in a circumferential direction of the susceptor 12 is formed in the susceptor 12, as will be elaborated later. A low-temperature heat exchange medium such as cooling water or Galden (registered trademark) is supplied into and circulated through the annular medium path from a chiller unit (not shown) through a medium pipeline. The susceptor 12 cooled by the heat exchange medium cools in turn the wafer W and the focus ring 25 via the electrostatic chuck 23. Further, the annular medium path may not only be used for cooling but also be used for maintaining a room temperature or heating. Accordingly, any of generally used heat exchange mediums may be used as a flowing medium that flows through the annular medium path, and the annular medium path may be used as an annular medium path for heat exchange.

A multiple number of heat transfer gas supply holes 28 are formed through a surface (hereinafter, referred to as an "attraction surface") of the electrostatic chuck 23 on which the wafer W is held. The heat transfer gas supply holes 28 are connected with a heat transfer gas supply unit (not shown) via a heat transfer gas supply line 29. The heat transfer gas supply unit supplies a helium (He) gas as a heat transfer gas into a gap between the attraction surface of the electrostatic chuck 23 and the rear surface of the wafer W through the heat transfer gas supply holes 28. The He gas supplied into the gap between the attraction surface of the electrostatic chuck 23 and the rear surface of the wafer W effectively transfers heat of the wafer W to the electrostatic chuck 23.

A shower head 30 is provided at a ceiling of the chamber 11 so as to face the susceptor 12 with a processing space S of the processing chamber 15 therebetween. The shower head 30 includes an upper electrode plate 31; a cooling plate 32 that detachably supports the upper electrode plate 31; and a cover body 33 that covers the cooling plate 32. The upper electrode plate 31 is formed of a circular plate-shaped member that has a multiple number of gas holes 34 formed in a thickness direction thereof. The upper electrode plate 31 is made of a semiconductor such as Si or SiC. Further, a buffer room 35 is formed within the cooling plate 32, and the buffer room 35 is connected with a processing gas inlet line 36.

The upper electrode plate 31 of the shower head 30 is grounded.

In the substrate processing apparatus 10 configured as described above, a processing gas supplied into the buffer room 35 through the processing gas inlet line 36 is introduced into the processing chamber 15 through the gas holes 34 of the upper electrode plate 31. The introduced processing gas is excited into plasma by the high frequency power for plasma generation applied into the processing chamber 15 from the second high frequency power supply 20 via the susceptor 12. Ions in the plasma are attracted toward the wafer W by the high frequency power for bias applied to the susceptor 12 from the first high frequency power supply 18, and a plasma etching process is performed on the wafer W.

An operation of each component of the substrate processing apparatus 10 is controlled by a CPU of a controller (not shown) included in the substrate processing apparatus 10 based on a program corresponding to the plasma etching process.

In this substrate processing apparatus 10, in order to uniformize radical density in the processing space S, a surface of the susceptor 12 is divided into a center area and an edge area surrounding the center area, and a temperature of the edge area is controlled to be lower than a temperature of the center area. Here, in order to prevent thermal efficiency from being deteriorated due to thermal conduction at an annular boundary between the center area and the edge area of the susceptor 12, a thermal insulator may be provided at the boundary between the center area and the edge area. However, although the thermal insulator can prevent a heat transfer between the center area and the edge area, it also serves as a thermal insulator for insulating heat generated in the processing space S when plasma is generated and introduced to the thermal insulator from above it. As a result, a hot spot is formed above the thermal insulator. Accordingly, it may not be possible to uniformize distribution of the radical density in the processing space S, and it may not be possible to improve the thermal efficiency.

The present inventor has conducted researches on an area temperature control structure having a multiple number of areas of which surface temperatures are controlled to have different temperatures. The inventor has investigated the thermal conduction between adjacent areas in an arrangement direction of the areas and thermal conduction between the areas in a direction intersecting with the arrangement direction of the areas. Through the researches, the inventor has found out that by providing anisotropic thermal conductive layers between the multiple number of areas, the thermal conduction between the multiple number of areas can be suppressed to maintain temperature differences therebetween. Meanwhile, the inventor has also found out that the thermal conduction in the direction intersecting with the arrangement direction of the areas can be facilitated to prevent the hot spot from being formed.

That is, the area temperature control structure in accordance with the illustrative embodiment includes at least two areas of which surface temperatures are controlled to have different temperatures; and an anisotropic thermal conductive layer provided between the at least two areas. A thermal conductivity of the anisotropic thermal conductive layer in an arrangement direction of the at least two areas is configured to be smaller than a thermal conductivity thereof in a direction intersecting with the arrangement direction of the at least two areas.

Now, a principle of the illustrative embodiment will be discussed with reference to the accompanying drawings.

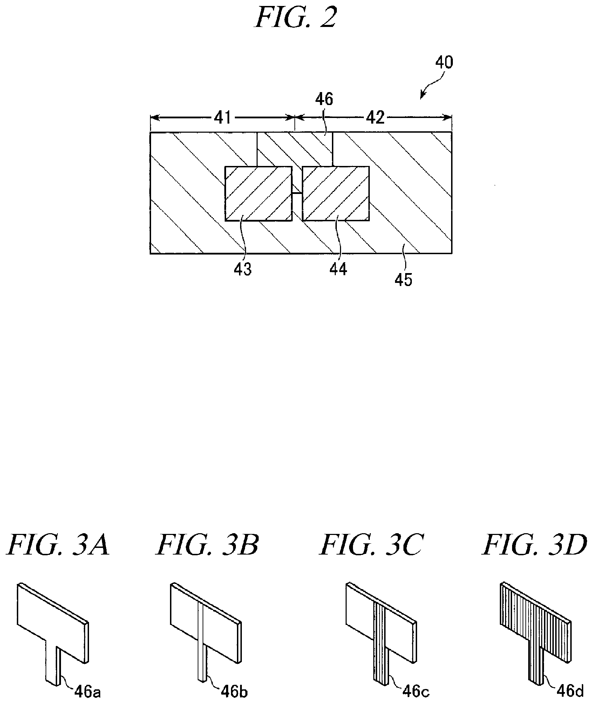

Fig. 2 is a cross sectional view illustrating a schematic configuration of an example area temperature control structure in accordance with the illustrative embodiment.

In Fig. 2, an area temperature control structure 40 configured as a part of the susceptor 12 mainly includes a structure main body 45 having a first annular temperature area 41 and a second annular temperature area 42 positioned adjacent to each other in a horizontal radial direction; a first annular medium path 43 as a first temperature control unit formed within the first annular temperature area 41; a second annular medium path 44 as a second temperature control unit formed within the second annular temperature area 42; and an annular boundary member 46 (anisotropic thermal conductive layer) provided between the first annular temperature area 41 and the second annular temperature area 42. The structure main body 45 is made of an isotropic thermal conductive material such as carbon. Further, in the following description, for the convenience of explanation, the arrangement direction of the areas of which surface temperatures are controlled to have different temperatures is referred to as a "horizontal radial direction", and a direction intersecting with the arrangement direction of the areas is referred to as a "vertical direction".

The annular boundary member 46 has a T-shaped cross section orthogonal to a flowing direction of a heat exchange medium in the first and second annular medium paths 43 and 44 (in Figs. 3A to 3D, cross sectional pieces of annular boundary members are depicted). A vertical portion (hereinafter, referred to as a "partition portion") of the T-shaped cross section is positioned between the first annular temperature area 41 and the second annular temperature area 42, and both ends of a horizontal portion of the T-shaped cross section are positioned on upper portions of the first and second annular medium paths 43 and 44, respectively.

As for the area temperature control structure 40 having the above-described configuration, simulation models are prepared by using four annular boundary members 46a to 46d (cross sectional pieces) shown in Figs. 3A to 3D as the annular boundary member 46.

Figs. 3A to 3D are perspective views illustrating annular boundary members provided between the first annular temperature area 41 and the second annular temperature area 42 in Fig. 2.

Annular boundary member 46d in Fig. 3D is an embodiment of the invention.

As for the annular boundary member 46a shown in Fig. 3A, for example, a horizontal portion of a T-shaped cross section thereof has a length of, e.g., about 10 mm and a width of, e.g., about 5 mm, and a partition portion thereof has a length of, e.g., about 10 mm and a width of, e.g., about 1.7 mm. The entire annular boundary member 46a is made of an isotropic thermal conductive material, such as carbon, that allows isotropic thermal conduction.

As for the annular boundary member 46b shown in Fig. 3B, for example, a horizontal portion of a T-shaped cross section thereof has a length of, e.g., about 10 mm and a width of, e.g., about 5 mm, and a partition portion thereof has a length of, e.g., about 10 mm and a width of, e.g., about 0.5 mm. The horizontal portion of the annular boundary member 46b is made of carbon, and an entire partition portion is made of a thermal insulator such as titanium.

As for the annular boundary member 46c shown in Fig. 3C, the dimensions of a T-shaped cross section of this annular boundary member 46c are the same as those of the annular boundary member 46a shown in Fig. 3A. A horizontal portion of this annular boundary member 46c is made of, e.g., carbon, and an entire partition portion thereof is made of a thermal insulator such as titanium. This annular boundary member 46c is different from the annular boundary member 46a of Fig. 3A in that a multiple number of, e.g., five thermal insulating layers are formed at the partition portion thereof with an interval of, e.g., about 0.3 mm in a width direction of the partition portion (i.e., the horizontal radial direction). Each thermal insulating layer may have a width of, e.g., about 0.1 mm. The thermal insulating layer may be, e.g., titanium, the same as that used to form the partition portion of Fig. 3B. The partition portion of this annular boundary member 46c has a property of an anisotropic thermal conductive member (hereinafter, referred to as a "diagonal member"). This partition portion serves as, e.g., a thermal insulator for suppressing the thermal conduction in the horizontal radial direction while serving as a thermal conductor for allowing the thermal conduction in the vertical direction.

As for the annular boundary member 46d shown in Fig. 3D, the dimensions of a T-shaped cross section of this annular boundary member 46d are the same as those of the annular boundary member 46a shown in Fig. 3A. The entire portion of this annular boundary member 46d having a T-shaped cross section is made of, e.g., carbon. This annular boundary member 46d is different from the annular boundary member 46a of Fig. 3A in that a multiple number of thermal insulating layers are formed at the entire horizontal portion and the entire partition portion thereof with an interval of, e.g., about 0.3 mm in the horizontal radial direction. Each thermal insulating layer may have a width of, e.g., about 0.1 mm. Thus, the entire portion of this T-shaped annular boundary member 46d has a property of the diagonal member. This annular boundary member 46d serves as, e.g., a thermal insulator for suppressing the thermal conduction in the horizontal radial direction while serving as, e.g., a thermal conductor for allowing the thermal conduction in the vertical direction.

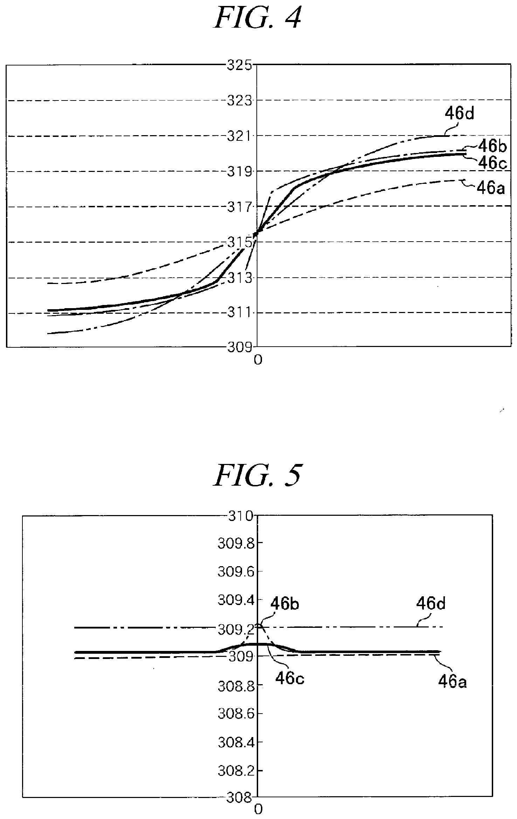

Simulations models are prepared by applying the annular boundary members 46a to 46d of Figs. 3A to 3D to the area temperature control structure 40 of Fig. 2 as the annular boundary member 46. In the experiment, a heat exchange medium of about 308 K (Kelvin) flows through the first annular medium path 43 of the first annular temperature area 41 and a heat exchange medium of about 323 K flows through the second annular medium path 44 of the second annular temperature area 42. Then, temperature distribution on the surfaces of the first and second annular temperature areas 41 and 42 in the horizontal radial direction of Fig. 2 is investigated. The experimental results are shown in Fig. 4.

Further, the heat exchange medium of about 308 K flows through both of the first annular medium path 43 and the second annular medium path 44, and heat caused by plasma generated by applying a power of about 28000 W/m² from above is measured. Then, temperature distribution on the surfaces of the first and second annular temperature areas 41 and 42 in the horizontal radial direction of Fig. 2 is investigated, and the experimental results are shown in Fig. 5.

Fig. 4 is a graph showing thermal conduction properties of the annular boundary members of Figs. 3A to 3D in the horizontal radial direction.

In Fig. 4, a vertical axis represents a temperature K of an area, and a horizontal axis represents a distance from an interface 0 between the first annular temperature area 41 and the second annular temperature area 42.

As depicted by a dashed line in Fig. 4, in the structure using the annular boundary member 46a of Fig. 3A, a surface temperature of the first annular temperature area 41 increases by being affected by a surface temperature of the second annular temperature area 42, whereas the surface temperature of the second annular temperature area 42 decreases by being affected by the surface temperature of the first annular temperature area 41. Accordingly, a boundary between the surface temperatures of the first and second annular temperature areas 41 and 42 is unclear. Further, since the first annular temperature area 41 and the second annular temperature area 42 are made of the isotropic thermal conductive material as described above, the surface temperature and an internal temperature of each area are identical to each other. Thus, in the following, the surface temperature and the internal temperature of each area may not be particularly distinguished but may be simply referred to as an area temperature.

As indicated by a dashed dotted line, in the structure using the annular boundary member 46b of Fig. 3B, a boundary between the area temperatures of the first and second annular temperature areas 41 and 42 is clear. This implies that the annular boundary member 46b functions as a thermal insulator for suppressing the thermal conduction in the arrangement direction of the first and second annular temperature areas 41 and 42.

Further, as indicated by a solid line, in the structure using the annular boundary member 46c of Fig. 3C, a boundary between the area temperatures of the first and second annular temperature areas 41 and 42 is clear, as in the case of the structure using the annular boundary member 46b of Fig. 3B. This implies that the annular boundary member 46c functions as a thermal insulator for suppressing the thermal conduction in the arrangement direction of the first and second annular temperature areas 41 and 42.

Further, as indicated by a dashed double-dotted line, in the structure using the annular boundary member 46d of Fig. 3D, a temperature difference between the first annular temperature area 41 and the second annular temperature area 42 is found to be increased as compared to those when using the annular boundary members 46b and 46c. This implies that the function of the annular boundary member 46d as a thermal insulator for suppressing the thermal conduction in the arrangement direction of the first and second annular temperature areas 41 and 42 is enhanced as compared to those of the annular boundary members 46b and 46c. Accordingly, when using the annular boundary member 46d, a first heat exchange medium flowing through the first annular medium path 43 and a second heat exchange medium flowing through the second annular medium path 44 may effectively perform cooling operation.

From the result of Fig. 4, it is found out that the annular boundary members 46b, 46c, and 46d are suitable for being used as the annular boundary member for maintaining the temperature difference between the first and second annular temperature areas 41 and 42.

Meanwhile, Fig. 5 is a graph showing thermal conduction properties of the annular boundary members of Figs. 3A to 3D in the vertical direction.

In Fig. 5, a vertical axis represents a temperature K of an area, and a horizontal axis represents a distance from an interface 0 between the first annular temperature area 41 and the second annular temperature area 42.

As shown by a dashed line in Fig. 5, in the structure using the annular boundary member 46a, heat may be easily transferred in the vertical direction, and, thus, the surface temperature of the structure main body 45 may be substantially uniformized to, e.g., about 309 K. It is because the entire annular boundary member 46a is made of the isotropic thermal conductive material so that the isotropic thermal conduction occurs.

In contrast, as indicated by a dashed dotted line, in the structure using the annular boundary member 46b, an area above the annular boundary member 46b becomes the hot spot of which temperature is higher than an ambient temperature. It is because the thermal insulating layer formed at the partition portion of the annular boundary member 46b functions as a thermal insulator for suppressing the thermal conduction in the vertical direction. As a result, a temperature singularity is formed above the annular boundary member 46b.

Further, as indicated by a solid line, in the structure using the annular boundary member 46c, although there is observed an area, of which temperature is slightly higher than an ambient temperature, above the annular boundary member 46c, this temperature is much lower than the temperature of the hot spot when using the annular boundary member 46b. Accordingly, this result implies that in the structure using the annular boundary member 46c, the diagonal member of the partition portion thereof does not function as a thermal insulator for suppressing the thermal conduction in the vertical direction but as a thermal conductor therefor.

Further, as indicated by a dashed double-dotted line, in the structure using the annular boundary member 46d, although the hot spot is not observed, thermal diffusion in the vertical direction is reduced overall. Accordingly, the entire surface temperature of the structure main body 45 is found to be increased as compared to those when using the other annular boundary members. This result implies that the annular boundary member 46d functions as a weak thermal insulator for suppressing the thermal conduction in the vertical direction.

Evaluations of the results of Figs. 4 and 5 are provided in Table 1.

In Table 1, the thermal insulation properties of the annular boundary members 46a to 46d of Figs. 3A to 3D in the horizontal radial direction and thermal conduction properties of the annular boundary members 46a to 46d in the vertical direction are evaluated. Here, a notation "○" indicates that a property is good; "Δ" indicates that a property is not good but not bad; and "×" indicates that a property is bad. Further, in the illustrative embodiment, the term "thermal insulation property" does not imply that heat is not transferred at all but implies that heat is difficult to be transferred.

**Table 1**

| Annular Boundary Member | 46a | 46b | 46c | 46d |
|---|---|---|---|---|
| Thermal Insulation Property in Horizontal Radial Direction | × | ○ | ○ | ○ |
| Thermal Conduction Property in Vertical Direction | ○ | × | ○ | Δ |

As can be seen from Table 1, the annular boundary member 46c of Fig. 3C having the diagonal member at the partition portion may be effectively used as an annular boundary member capable of serving as a thermal insulator for suppressing the thermal conduction in the horizontal radial direction while serving as a thermal conductor for allowing the thermal conduction in the vertical direction.

That is, as can be seen from the above result, in the area temperature control structure 40 of Fig. 2 having the first annular temperature area 41 and the second annular temperature area 42, in order to suppress generation of the hot spot due to the heat introduced from above the areas while maintaining the temperature difference between the first and second annular temperature areas 41 and 42, the diagonal member of which thermal conductivity in the horizontal radial direction is smaller than its thermal conductivity in the vertical direction needs to be provided between the first and second annular temperature areas 41 and 42. That is, the diagonal member capable of serving as a thermal insulator for suppressing the thermal conduction in the horizontal radial direction while serving as a thermal conductor for allowing the thermal conduction in the vertical direction needs to be provided.

Accordingly, in accordance with the illustrative embodiment, in the area temperature control structure having at least two areas of which surface temperatures are controlled to have different temperatures, the diagonal member of which the thermal conductivity in the horizontal radial direction is smaller than its thermal conductivity in the vertical direction is provided between the at least two areas.

Hereinafter, the area temperature control structure in accordance with a first illustrative embodiment will be explained.

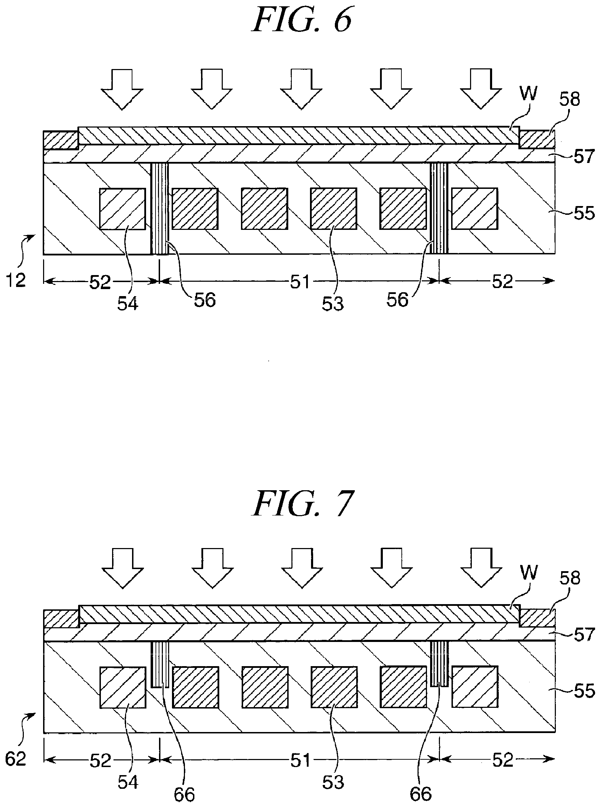

Fig. 6 is a cross sectional view illustrating a schematic configuration of the susceptor serving as the area temperature control structure in accordance with the first illustrative embodiment.

In Fig. 6, the susceptor 12 includes a susceptor main body 55, a first annular medium path 53, a second annular medium path 54, and a diagonal member 56. The susceptor main body 55 has a center area 51 as a first annular temperature area and an edge area 52 as a second annular temperature area. The first annular medium path 53 is formed within the center area 51 of the susceptor main body 55, and the second annular medium path 54 is formed within the edge area 52 of the susceptor main body 55. The diagonal member 56 is disposed between the first annular medium path 53 and the second annular medium path 54, and is made of an anisotropic thermal conductive material. The susceptor main body 55 is made of an isotropic thermal conductive material, e.g., metal aluminum.

The susceptor 12 is of a circular plate shape. A diameter of the susceptor 12 is in the range of, e.g., from about 320 mm to about 400 mm, and a thickness of the susceptor 12 is in the range of, e.g., from about 20 mm to about 50 mm. However, these numerical values may vary depending on a size of the wafer W mounted on the susceptor 12. The wafer W is mounted on a top surface of the susceptor 12 via an electrostatic chuck 57. A focus ring 58 is provided to surround the wafer W that is attracted and held on the electrostatic chuck 57. The center area 51 of the susceptor 12 is cooled by a relatively high-temperature heat exchange medium flowing through the first annular medium path 53. The edge area 52 of the susceptor 12 is cooled by a relatively low-temperature heat exchange medium flowing through the second annular medium path 54.

The diagonal member 56 is disposed between the first annular medium path 53 and the second annular medium path 54, i.e., at a boundary between the center area 51 and the edge area 52. Further, the diagonal member 56 penetrates through the susceptor main body 55 in a thickness direction thereof. Accordingly, the diagonal member 56 has an annular shape disposed between the center area 51 of a circular plate shape and the edge area 52 of an annular shape.

A temperature of the wafer W mounted on the susceptor 12 having the above-described configuration depends on a temperature of the center area 51 and a temperature of the edge area 52 in the surface of the susceptor 12. Furthermore, the temperature of the wafer W depends on a temperature of a heat exchange medium flowing through the first annular medium path 53 within the center area 51 and a temperature of a medium flowing through the second annular medium path 54 within the edge area 52.

The susceptor 12 of Fig. 6 is disposed within the chamber 11 of the substrate processing apparatus 10 of Fig. 1. A heat exchange medium of, e.g., about 323 K flows through the first annular medium path 53, and a heat exchange medium of, e.g., about 308 K flows through the second annular medium path 54. The processing gas is introduced into the processing chamber 15, and by applying the high frequency power for plasma generation from the second high frequency power supply 20 via the susceptor 12, the processing gas is excited into plasma. In such a case, the surface temperature of the center area 51 of the susceptor 12 becomes slightly higher than about 323 K, e.g., about 324 K, and the surface temperature of the edge area 52 becomes slightly higher than about 308 K, e.g., about 309 K. Heat caused by the plasma and introduced from the processing space S is uniformly transferred to the entire surface of the susceptor 12, and the hot spot is not formed above the diagonal member 56. Arrows above the wafer W indicate the heat accompanied by the generation of the plasma.

In accordance with the present illustrative embodiment, by suppressing the thermal conduction in the horizontal radial direction in the susceptor 12 having the center area 51 and the edge area 52 controlled to have different temperatures, it is possible to maintain a temperature difference between the two areas. Further, by allowing the heat introduced from the vertical direction to be transferred uniformly, it is possible to prevent the hot spot from being formed and to improve the thermal efficiency.

Moreover, in accordance with the present illustrative embodiment, since the diagonal member 56 is provided to penetrate through the susceptor main body 55 in the thickness direction of the susceptor main body 55, it is possible to achieve a high thermal insulation effect for suppressing the thermal conduction in the horizontal radial direction. Accordingly, the interference between the heat exchange mediums can be reduced. As a result, an energy loss can also be suppressed. The susceptor 12 of the present illustrative embodiment may be effectively used to maintain the temperature difference between the center area 51 and the edge area 52 in the surface of the susceptor 12 and to improve the thermal efficiency of the entire susceptor 12.

In the present illustrative embodiment, a thickness of the diagonal member 56 in the horizontal radial direction may depend on the thermal insulation level required between the center area 51 and the edge area 52. That is, if strong thermal insulation is required, the thickness of the diagonal member 56 may become thick. If weak thermal insulation is sufficient, on the other hand, the thickness of the diagonal member 56 may become thin. By making the thickness of the diagonal member 56 thick, a side surface of the diagonal member 56 may contact with side surfaces of the first annular medium path 53 and the second annular medium path 54. If it becomes difficult to maintain physical strength of the entire susceptor 12 by allowing the diagonal member 56 to contact with both or either one of the first annular medium path 53 and the second annular medium path 54, it may be desirable to strengthen both or either one of the side surfaces of the first annular medium path 53 and the second annular medium path 54, or the susceptor main body 55 itself. Further, it is desirable that the diagonal member 56 be made of a material having a thermal expansion coefficient equal to that of the susceptor main body 55, or a material capable of absorbing a difference in thermal expansion between the diagonal member 56 and other members adjacent thereto.

In the present illustrative embodiment, the number of the annular temperature areas controlled to have different temperatures is two, i.e., the center area 51 and the edge area 52. However, the number of the annular temperature areas is not limited to two and may be three or more.

In the present illustrative embodiment, the diagonal member 56 functions as a thermal insulator for suppressing the thermal conduction in the horizontal radial direction while functioning as a thermal conductor for allowing the thermal conduction in the vertical direction. Further, the diagonal member 56 may be desirably made of a composite material selected from titan (Ti)-carbon (C), alumimium (Al)-carbon fiber, titan-aluminum, and glass-shaped carbon-carbon.

In the present illustrative embodiment, the thermal conductivity of the diagonal member 56 in the horizontal radial direction and the thermal conductivity of the diagonal member 56 in the vertical direction may be determined relatively by their mutual relationship. Specifically, if the materials used for the diagonal member are titan-carbon, a thermal conductivity of the diagonal member in a direction in which heat transfer is difficult to occur becomes, e.g., about 10 W/(m·K), and a thermal conductivity in a direction in which heat transfer is easy to occur becomes, e.g., about 200 W/(m·K). If the materials therefor are aluminum-carbon fiber, these thermal conductivities become, e.g., about 150 W/(m·K) and about 1000 W/(m·K), respectively. If the materials therefor are glass-shaped carbon-carbon, the thermal conductivities become, e.g., about 10 W/(m·K) and about 200 W/(m·K), respectively. If the materials therefor are titan-aluminium, the thermal conductivities become, e.g., about 10 W/(m·K) and about 150 W/(m·K), respectively. Accordingly, a ratio of the thermal conductivity of the diagonal member 56 in the vertical direction to the thermal conductivity of the diagonal member 56 in the horizontal radial direction needs to be set to be equal to or larger than about 7.

In the present illustrative embodiment, the temperature control units provided within the center area 51 and the edge area 52 are the annular medium paths through which the heat exchange mediums flow. However, in the present illustrative embodiment, the temperature control units may not be limited to the annular medium paths but may be thermoelectric elements (e.g., Peltier elements), or other types of heaters such as resistance heating elements. By providing the annular medium paths, the thermoelectric elements, the resistance heating elements, and the like as the temperature control units, the temperature control units can be easily controlled and long lifetime thereof can be obtained.

Hereinafter, a modification example of the first illustrative embodiment will be described.

Fig. 7 is a cross sectional view illustrating a modification example of the susceptor of Fig. 6.

A susceptor 62 in Fig. 7 is different from the susceptor 12 of Fig. 6 in that a diagonal member 66 extended from a top surface of the susceptor main body 55 to a middle point in the thickness direction of the susceptor main body 55 is used instead of the diagonal member 56 penetrating through the susceptor main body 55 in the thickness direction of the susceptor main body 55.

In accordance with this modification example, as in the susceptor 12 of Fig. 6, it is possible to maintain the temperature difference between the center area 51 and the edge area 52 by suppressing the thermal conduction at an interface between the center area 51 and the edge area 52 in a horizontal radial direction. Further, it is also possible to prevent the hot spot from being formed above the diagonal member 66 by allowing heat caused by plasma and introduced from above the susceptor 62 to be transferred uniformly.

The susceptor 62 of this modification example may be effectively used when it is required to maintain the temperature difference between the center area 51 and the edge area 52 in the surface of the susceptor 62 even if the thermal efficiency of the entire susceptor 62 is reduced to some degree.

Now, an area temperature control structure in accordance with a second illustrative embodiment will be described.

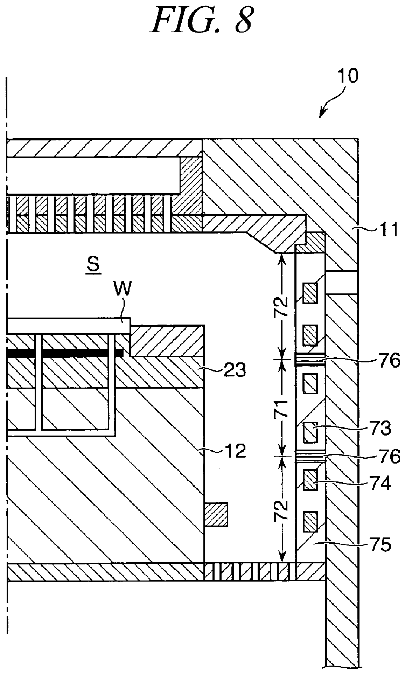

Fig. 8 is a cross sectional view illustrating a deposit shield (hereinafter, referred to as "annular deposit shield") serving as the area temperature control structure in accordance with the second illustrative embodiment.

The annular deposit shield is provided within a chamber of a substrate processing apparatus. A surface temperature of the annular deposit shield is set to have a relatively high surface temperature so that a deposit may be prevented from adhering thereto. Typically, the surface temperature of the annular deposit shied is set to, e.g., from about 400 K to about 450 K. However, in order to protect a sensor or the like provided at the annular deposit shield, deposits may need to be formed so as to cover only a portion thereof corresponding to an installation position of the sensor. In this case, a temperature of only the portion thereof corresponding to the installation position of the sensor may be controlled to be lower than an ambient temperature, so that deposits may be easily formed on that portion. This annular deposit shield serves as the area temperature control structure.

In Fig. 8, an annular deposit shield 75 is provided on a side wall of the chamber 11 of the substrate processing apparatus 10. The annular deposit shield 75 may be made of an isotropic thermal conductive material, e.g., aluminum. The annular deposit shield 75 is divided into a low temperature area 71 and a high temperature area 72. An annular medium path 73 for a low temperature is formed in the low temperature area 71, and an annular medium path 72 for a high temperature is formed in the high temperature area 72. A diagonal member 76 is disposed at a boundary between the low temperature area 71 and the high temperature area 72 while penetrating through the annular deposit shield 75 in a thickness direction of the annular deposit shield 75.

By using the substrate processing apparatus 10 including the annular deposit shield 75 having the above-described configuration, a plasma process is performed on the wafer W mounted on the top surface of the susceptor 12 via the electrostatic chuck 23. A heat exchange medium of, e.g., about 308 K flows through the low-temperature annular medium path 73 of the annular deposit shield 75, and a heat exchange medium of, e.g., about 400 K flows through the high-temperature annular medium path 74. In such a case, a surface temperature of the low temperature area 71 may become, e.g., about 310 K, and a surface temperature of the high temperature area 72 may become, e.g., about 398 K. Accordingly, a temperature difference between the two areas can be properly maintained. Further, it is also possible to prevent the hot spot from being formed above the diagonal member 76 due to heat caused by plasma and introduced from the processing space S.

In accordance with the second illustrative embodiment, the temperature difference between the low temperature area 71 and the high temperature area 72 can be secured, and the hot spot due to the heat caused by the plasma and introduced from the processing space S can be prevented from being formed. Accordingly, the heat can be conducted uniformly over the whole areas.

Next, an area temperature control structure in accordance with a third illustrative embodiment will be described.

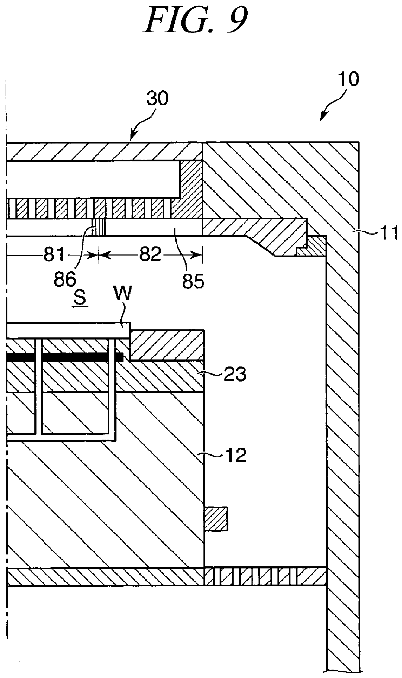

Fig. 9 is a cross sectional view illustrating an upper electrode plate serving as the area temperature control structure in accordance with the third illustrative embodiment.

The upper electrode plate serves as a part of the shower head for supplying the processing gas into the processing space S. The upper electrode plate is configured as an electrode when applying the high frequency power into the processing space S to excite the processing gas into plasma. Further, the upper electrode plate is also configured as the area temperature control structure when generating a temperature difference between a center area and an edge area thereof.

In Fig. 9, an upper electrode plate 85 is configured as a part of the shower head 30 provided within the chamber 11 of the substrate processing apparatus 10 and is made of the isotropic thermal conductive material. For example, the upper electrode plate 85 is made of, e.g., Si and has a circular plate shape having a diameter of, e.g., from about 300 mmϕ to about 500 mmϕ, and a thickness of, e.g., from about 5 mm to about 10 mm. The upper electrode plate 85 is positioned to face the wafer W mounted on a top surface of the susceptor 12 via the electrostatic chuck 23 with the processing space S therebetween. The upper electrode plate 85 has an electrode plate center area 81 and an electrode plate edge area 82 facing the center area 51 and the edge area 52 of the susceptor 12 illustrated in Fig. 6, respectively. A diagonal member 86 is disposed at a boundary between the electrode plate center area 81 and the electrode plate edge area 82 so as to penetrate through the upper electrode plate 85 in a thickness direction thereof.

In the upper electrode plate 85 having the above-described configuration, the electrode plate center area 81 and the electrode plate edge area 82 are controlled to have different temperatures, like the center area 51 and the edge area 52 of the susceptor 12 of Fig. 6. These areas may receive heat caused by plasma in the processing space S and introduced from below in Fig. 9. By disposing the diagonal member 86 between the electrode plate center area 81 and the electrode plate edge area 82, however, the temperature difference between the electrode plate center area 81 and the electrode plate edge area 82 can be maintained, and the heat accompanied by the plasma generation in the processing space S can be uniformly transferred on a bottom surface of the upper electrode plate 85 in Fig. 9. As a result, the hot spot can be prevented from being formed.

While various aspects and embodiments have been described herein, the various aspects and embodiments disclosed herein are for the purposes of illustration and are not intended to be limiting. The present invention is defined by the appended claims.

## Claims

1. An area temperature control structure (40) comprising:
a structure main body (45), which is made of an isotropic thermal conductive material, including a first area (41) and a second area (42) of which surface temperatures are controlled to have different temperatures;
a first annular medium path (43) and a second annular medium path (44) formed within the first and second areas (41, 42), respectively; and
an anisotropic thermal conductive layer (46) provided within the structure main body (45),
wherein a thermal conductivity of the anisotropic thermal conductive layer (46) in an arrangement direction of the first and second areas (41, 42) is smaller than a thermal conductivity of the anisotropic thermal conductive layer (46) in a direction intersecting with the arrangement direction of the first and second areas (41, 42),
**characterized in that** the anisotropic thermal conductive layer (46) has a T-shaped cross section,
the T-shaped cross section is orthogonal to a flowing direction of a heat exchange medium in the first annular medium path (43) and the second annular medium path (44),
a vertical portion of the T-shaped cross section is positioned between the first annular medium path (43) and the second annular medium path (44), and both ends of a horizontal portion of the T-shaped cross section are positioned on upper portions of the first and second annular medium paths (43, 44), respectively, and
the vertical portion and the horizontal portion of the anisotropic thermal conductive layer (46) are all made of an anisotropic thermal conductive material.

2. The area temperature control structure (40) of claim 1,
wherein a ratio of the thermal conductivity of the anisotropic thermal conductive layer (46) in the direction intersecting with the arrangement direction of the first and second areas (41, 42) to the thermal conductivity thereof in the arrangement direction of the first and second areas (41, 42) is equal to or larger than about 7.

3. The area temperature control structure (40) of claim 1,
wherein the anisotropic thermal conductive layer (46) is made of a composite material selected from titan-carbon, aluminum-carbon fiber, titan-aluminum, and glass-shaped carbon-carbon.

4. The area temperature control structure (40) of claim 1,
wherein the area temperature control structure (40) is a plate-shaped structure in which the first and second areas (41, 42) are arranged in a predetermined direction, and the anisotropic thermal conductive layer (46) is formed to penetrate through the plate-shaped structure in a thickness direction thereof.

5. The area temperature control structure (40) of claim 1,
wherein the area temperature control structure (40) is a mounting table, an upper electrode plate, or a deposit shield of a substrate processing apparatus.

## Patentansprüche

1. Bereichstemperatursteueraufbau (40) umfassend:
einen Aufbauhauptkörper (45), der aus einem isotropen thermisch leitenden Material besteht und einen ersten Bereich (41) und einen zweiten Bereich (42) aufweist, deren Oberflächentemperaturen so gesteuert werden, dass sie verschiedene Temperaturen aufweisen;
einen ersten ringförmigen Mediumpfad (43) und einen zweiten ringförmigen Mediumpfad (44), die in dem ersten bzw. zweiten Bereich (41, 42) geformt sind; und
eine anisotrope thermisch leitende Schicht (46), die in dem Aufbauhauptkörper (45) vorgesehen ist,
wobei eine thermische Leitfähigkeit der anisotropen thermisch leitenden Schicht (46) in einer Anordnungsrichtung des ersten und zweiten Bereiches (41, 42) kleiner als eine thermische Leitfähigkeit der anisotropen thermisch leitenden Schicht (46) in einer Richtung ist, die die Anordnungsrichtung des ersten und zweiten Bereiches (41, 42) schneidet,
**dadurch gekennzeichnet, dass** die anisotrope thermisch leitende Schicht (46) einen T-förmigen Querschnitt aufweist,
der T-förmige Querschnitt rechtwinklig zu einer Strömungsrichtung eines Wärmeaustauschmediums in dem ersten ringförmigen Mediumpfad (43) und dem zweiten ringförmigen Mediumpfad (44) ist,
ein vertikaler Abschnitt des T-förmigen Querschnitts zwischen dem ersten ringförmigen Mediumpfad (43) und dem zweiten ringförmigen Mediumpfad (44) positioniert ist und beide Enden eines horizontalen Abschnitts des T-förmigen Querschnitts an oberen Abschnitten des ersten bzw. zweiten ringförmigen Mediumpfades (43, 44) positioniert sind, und
der vertikale Abschnitt und der horizontale Abschnitt der anisotropen thermisch leitenden Schicht (46) alle aus einem anisotropen thermisch leitendem Material bestehen.

2. Bereichstemperatursteueraufbau (40) nach Anspruch 1,
wobei ein Verhältnis der thermischen Leitfähigkeit der anisotropen thermisch leitenden Schicht (46) in der Richtung, die die Anordnungsrichtung des ersten und zweiten Bereiches (41, 42) schneidet, zu seiner thermischen Leitfähigkeit in der Anordnungsrichtung des ersten und zweiten Bereiches (41, 42) gleich oder größer als etwa 7 ist.

3. Bereichstemperatursteueraufbau (40) nach Anspruch 1,
wobei die anisotrope thermisch leitende Schicht (46) aus einem Verbundmaterial besteht, das aus Titan-Kohlenstoff, Aluminium-Kohlenstoff-Faser, Titan-Aluminium und glasförmigem Kohlenstoff-Kohlenstoff gewählt ist.

4. Bereichstemperatursteueraufbau (40) nach Anspruch 1,
wobei der Bereichstemperatursteueraufbau (40) ein plattenförmiger Aufbau ist, bei dem der erste und zweite Bereich (41, 42) in einer vorbestimmten Richtung angeordnet sind, und die anisotrope thermisch leitende Schicht (46) so geformt ist, dass sie in den plattenförmigen Aufbau in seiner Dickenrichtung eindringt.

5. Bereichstemperatursteueraufbau (40) nach Anspruch 1,
wobei der Bereichstemperatursteueraufbau (40) ein Montagetisch, eine obere Elektrodenplatte oder eine Abscheidungsabschirmung einer Substrat verarbeitenden Vorrichtung ist.

## Revendications

1. Structure de commande de température par zone (40) comprenant :
un corps principal de structure (45), qui est fait d'un matériau thermoconducteur isotrope, incluant une première zone (41) et une seconde zone (42) dont les températures de surface sont commandées pour avoir différentes températures ;
un premier trajet de fluide annulaire (43) et un second trajet de fluide annulaire (44) formés dans la première et dans la seconde zone (41, 42) respectivement ; et
une couche thermoconductrice anisotrope (46) prévue à l'intérieur du corps principal de structure (45),
dans laquelle une conductivité thermique de la couche thermoconductrice anisotrope (46) dans une direction d'agencement de la première et de la seconde zone (41, 42) est plus faible qu'une conductivité thermique de la couche thermoconductrice anisotrope (46) dans une direction qui recoupe la direction d'agencement de la première et de la seconde zone (41, 42),
**caractérisée en ce que** la couche thermoconductrice anisotrope (46) a une section transversale en forme de T,
la section transversale en forme de T est perpendiculaire à une direction d'écoulement d'un fluide d'échange de chaleur dans le premier trajet de fluide annulaire (43) et le second trajet de fluide annulaire (44),
une portion verticale de la section transversale en forme de T est positionnée entre le premier trajet de fluide annulaire (43) et le second trajet de fluide annulaire (44), et les deux extrémités d'une portion horizontale de la section transversale en forme de T sont positionnées sur les portions supérieures du premier et du second trajet de fluide annulaire (43, 44), respectivement, et
la portion verticale et la portion horizontale de la couche thermoconductrice anisotrope (46) sont toutes faites d'un matériau thermoconducteur anisotrope.

2. Structure de commande de température par zone (40) selon la revendication 1,
dans lequel un rapport de la conductivité thermique de la couche thermoconductrice anisotrope (46) dans la direction qui recoupe la direction d'agencement de la première et de la seconde zone (41, 42) sur la conductivité thermique de celles-ci dans la direction d'agencement de la première et de la seconde zone (41, 42) est égal ou supérieur à environ 7.

3. Structure de commande de température par zone (40) selon la revendication 1,
dans laquelle la couche thermoconductrice anisotrope (46) est faite d'un matériau composite sélectionné parmi le titane/carbone, des fibres aluminium/carbone, aluminium-titane et un matériau carbone/carbone en forme de verre.

4. Structure de commande de température par zone (40) selon la revendication 1,
dans laquelle la structure de commande de température par zone (40) est une structure en forme de plaque dans laquelle la première et la seconde zone (41, 42) sont agencées dans une direction prédéterminée, et la couche thermoconductrice anisotrope (46) est formée pour pénétrer à travers la structure en forme de plateau dans une direction de l'épaisseur de celle-ci.

5. Structure de commande de température par zone (40) selon la revendication 1,
dans laquelle la structure de commande de température par zone (40) est une table de montage, une plaque électrode supérieure, ou un écran de déposition d'un appareil de traitement de substrat.
